# EUROPEAN PATENT APPLICATION

(11) **EP 3 605 605 A1**
(43) Date of publication of application: **05.02.2020**
(21) Application number: 18306049.0
(22) Date of filing: 01.08.2018
(51) Int. Cl.: H01L 25/16, H01L 33/10, H01L 31/0232, B60S 1/08

(54) **OPTICAL EMITTER-RECEIVER SYSTEM, LIGHT BARRIER, AND RAIN SENSOR**

(71) Applicant: MEAS France, 31027 Toulouse Cedex 3 (FR)
(72) Inventor: DURUPT, Emilien, 31460 Francarville (FR); ANDREU, Damien, 31400 Toulouse (FR)
(74) Representative: Grünecker Patent- und Rechtsanwälte PartG mbB

(57) **Abstract**

The present invention relates to an optical emitter-receiver system comprising at least one optical emitter (300, 410) comprising at least one first resonant cavity light emitting diode (RCLED) with first active region (301) comprising a p-n junction diode configured to emit light when activated, two first spacer regions (302) on each side of the first active region (301), and a first Fabry-Perot cavity (303, 304), and at least one optical receiver (300, 412) comprising at least one second resonant cavity photodiode (RCPD) with a second active region (301) comprising a p-n junction diode configured to convert light into an electrical current, two second spacer regions (302) on each side of the second active region (301), and a second Fabry-Perot cavity (303, 304), wherein the RCPD is arranged such as to detect light emitted by the RCLED, and wherein the emission spectrum of the optical emitter matches the absorption spectrum of the optical receiver. The present invention also relates to a light barrier and a rain sensor comprising such an emitter-receiver system.

## Description

The present invention relates to optical radiation transmitting systems comprising at least one emitter and at least one receiver.

Many optical emitter-receiver sensor systems rely on light as the signal source. The signal source often comprises a light-emitting diode (LED). As this is known to a person skilled in the art, an LED is a semiconductor light source with two electrical connections and comprising a p-n junction diode. A p-n junction is a boundary between two types of semiconductor materials, p-type and n-type, inside a single crystal of semiconductor. The "p" (positive) side contains an excess of holes, while the "n" (negative) side contains an excess of electrons in the outer shells of the electrically neutral atoms there. This allows electrical current to pass through the junction only in one direction. The LED emits light when a suitable voltage is applied to the electrical connections.

The semiconductor crystal of many LEDs is brazed on a cone-shaped cavity of a metal bracket. The inner sides of the cavity serve as reflector for the light exiting from all sides of the LED, and at the same time they take up the heat emerging due to the fact that the diode only converts part of the electrical energy into light.

For leaded LEDs the mount with the reflector is made as a wire with rectangular cross section which serves as electrical connection. Different from what is common for other electronic elements the connecting lead does not consist of tinned copper but of tinned steel. Steel exhibits a low heat conductivity. This avoids overheating of the semiconductor crystal when the element is soldered into a conductor board. The electrical connection of the upper side of the crystal to the second steel lead is implemented via a thin bond wire such that the connection covers only little of the light emitting surface.

When a suitable voltage is applied, electrons are able to recombine with electron holes within the device, releasing energy in the form of photons. This effect is called electroluminescence, and the color of the light (corresponding to the energy of the photon) is determined by the energy band gap of the semiconductor.

The second component in a sensor system is the receiver of the signal. Widely employed systems for receiving optical signals are photodiodes. A photodiode (PD) is a semiconductor device that converts light into an electrical current. The current is generated when photons are absorbed in the photodiode.

LEDs are used for a variety of applications including indicators and signs, lighting, data communication and other signaling, sustainable lighting, light sources for machine vision systems, as well as optical fiber and free space communications. In particular, infrared LEDs are often used in remote controls, such as for TVs, VCRs, and LED Computers. Opto-isolators use an LED combined with a photodiode or phototransistor to provide a signal path with electrical isolation between two circuits.

A typical LED comprises a top electrode, a substrate, a top confining layer, an active layer, a bottom confining layer, a bottom contact layer, a centrally located bottom electrode of relatively small area, a dielectric layer upon the remainder of the bottom contact layer, and a heat-sink. The top electrode has a centrally located aperture through which the spontaneous light emission takes place.

The transfer function of an optoelectronic emitter/receiver couple (such as an LED/photodiode pair) corresponds to the spectral overlap between the spectrum of the emitter and the efficient absorption spectrum of the receiver (i.e. the fraction of the absorption spectrum of the receiver in which the absorbed photons are generating a photocurrent). The accuracy of such emitter-receiver sensor systems is limited by the fact that the receivers may also detect ambient light.

Usually, in optically perturbed applications, the PD surface is coated with a low cost pigmented filter in order to minimize the influence of the non-desired wavelengths (i.e. suppress UV and visible radiation in the frame of infrared LED domain). However, this solution has the disadvantage that the sensitivity is reduced because energy is lost in the filter.

Consequently, there is a need for an improved optical emitter-receiver system that has a high sensitivity and at the same time is not impaired by interfering radiation.

This object is solved by an optical emitter-receiver system comprising at least one optical emitter comprising at least one resonant cavity light emitting diode (RCLED) with an active layer comprising a p-n junction diode configured to emit light when activated, a spacer region on each side of the active region, and a Fabry-Perot cavity, for instance formed by a highly reflective multilayer distributed Bragg reflector (DBR) with a reflectivity greater than 0.99, and a mirror with a low to moderate reflectivity between 0.25 and 0.99 for selecting optical modes, and at least one optical receiver comprising a resonant cavity photodiode (RCPD) which has an active layer comprising a p-n junction diode configured to convert light into an electrical current, a spacer region on each side of the active region, and a Fabry-Perot cavity, for instance formed by a highly reflective multilayer DBR with a reflectivity greater than 0.99 and a mirror with a low to moderate reflectivity between 0.25 and 0.99 for selecting optical modes, wherein the RCPD is arranged such as to detect light emitted by the RCLED, and wherein the emission spectrum of the optical emitter matches the absorption spectrum of the optical receiver. Such a device will have a higher signal-to-noise ratio than an optical emitter-receiver system comprising only a conventional LED and a conventional PD.

One of the earliest implementations of an RCLED as an improved LED is disclosed in EP 0 550 963 A1. Accordingly, an LED is disclosed in which an optical cavity of the LED, which includes an active layer and confining layers, is within a resonant Fabry-Perot cavity. The LED with the resonant cavity, hereinafter called Resonant Cavity LED or RCLED, has a higher spectral purity and higher light emission intensity relative to conventional LEDs.

The Fabry-Perot cavity is formed by a highly reflective multilayer distributed Bragg reflector (DBR) mirror with a reflectivity greater than 0.99 and a mirror with a low to moderate reflectivity similar to 0.25-0.99, for example, by the interface between a contact layer and air in an aperture in a top electrode. The DBR mirror, placed in the RCLED structure between the substrate and the confining bottom layer, is used as a bottom mirror. Presence of the less reflective top mirror above the active region leads to an unexpected improvement in directional light emission characteristics. The use of a Fabry-Perot resonant cavity formed by these two mirrors results in optical spontaneous light emission from the active region, which is restricted to the modes of the cavity.

While the bottom DBR mirror reduces absorption by the substrate of that light portion which is emitted toward the substrate, the two mirrors of the resonant cavity reduce the isotropic emission and improve the light emission characteristics in terms of a more directed (anisotropic) emission.

RCLEDs are used as high efficiency light source in communication and non-communication applications. RCLEDs can serve a broad range of low cost, high volume applications, both communication and non-communication, and this for a broad range of applications.

Furthermore, as disclosed in US 5 493 577 A, the semiconductor light emitting device may be provided with a control layer or control region which includes an annular oxidized portion thereof to channel an injection current into the active region, and to provide a lateral refractive index profile for index guiding the light generated within the device.

Also a PD may be put into a resonant cavity. Such a resonant cavity photodiode (RCPD) has, e.g., been used in document EP 1 309 051 A1. This document discloses an optical data transfer pathway containing a surface emitting laser diode with a vertical resonator and a photodiode with resonance cavity. Specifically, the optical data path comprises a VCSEL for providing a light output, said VCSEL device having a resonant reflector integrated therewith, wherein the resonant reflector has an orientation that polarizes the light output in a first direction; and a first resonant cavity photodiode RCPD having a resonant type reflector integrated therewith wherein said resonant reflector of said first RCPD device has the same orientation as said VCSEL device such that said first RCPD device detects the polarized light output of said VCSEL device.

VCSELs, though, are significantly more expensive than RCLEDs. Therefore, the present invention has the advantage of being more economic by emission-detector systems comprising RCPDs involving RCLEDs rather than VCSELs. Thus, the current invention provides an optical emitter-receiver system comprising a p-n junction diode configured to emit light when activated and residing in a Fabry-Perot cavity, denoted as resonant cavity light emitting diode (RCLED), and a p-n junction diode configured to convert light into electrical current and residing in a Fabry-Perot cavity, denoted as resonant cavity photodiode (RCPD), the RCPD being configured such as to detect light emitted by the RCLED. An additional advantage of RCLEDs in this context is the broader light intensity vs emission angle they provide with respect to VECSELs which allows to shine a larger area in case of spatial sensing measurement chains as Light barrier or Rain sensor.

Designing the emitter-receiver system such as to match the emission spectrum of the optical emitter and the absorption spectrum of the optical receiver may include to choose identical active regions for the emitter and the receiver. Therefore, in one embodiment of the invention, the at least one optical emitter and the at least one optical receiver may have identical active regions. For an emitter-receiver system as described above with identical active regions in the emitter and receiver, the emission spectrum of the optical emitter and the absorption spectrum of the optical receiver will not automatically match but based on the identity of the active regions in the emitter and receiver, matching the emission spectrum of the emitter and the absorption spectrum of the receiver by adapting other aspects of the design of the optical emitter-receiver system will be facilitated.

The optical modes of the cavity depend on the length of the cavity and, therefore, in particular, on the thickness of the spacer regions of the emitter and the receiver. In order to facilitate matching of the emission spectrum of the emitter and the absorption spectrum of the receiver, in one embodiment of the invention the cavities of the emitter and the receiver are equal in length. In particular, in one embodiment of the invention, the spacer regions of the emitter and the receiver all have the same thickness. This design will facilitate to match the emission spectrum of the emitter and the absorption spectrum of the receiver.

In matching the emission spectrum of the emitter and the absorption spectrum of the receiver, also the mirrors play a role. The higher the reflectivity of the mirrors, the narrower the maxima of the individual optical modes of the cavity. In other words, the lower the reflectivity of the mirrors, the broader the maxima of the individual optical modes of the cavity. In order to facilitate to match the emission spectrum of the emitter and the absorption spectrum of the receiver, the reflectivities of the two mirrors of the at least one optical emitter and the at least one optical receiver should be chosen similar to each other. Therefore, in one embodiment of the invention, in particular, the mirror with a low to moderate reflectivity of the emitter and the mirror with a low to moderate reflectivity of the receiver have the same reflectivities. This design will facilitate to match the emission spectrum of the emitter and the absorption spectrum of the receiver.

In another embodiment of the invention, the at least one optical emitter and the at least one optical receiver are formed by an identical optoelectronic component. This design will facilitate to match the emission spectrum of the emitter and the absorption spectrum of the receiver.

In some embodiments of the present invention, the at least one optical emitter and the at least one optical receiver are formed by an identical optoelectronic component. This means, in particular, that the emitter and the receiver including their spacer regions have the same geometry and consist of the same materials. This has the advantage that both have the same temperature characteristics which is important for a high signal-to-noise ratio over a broad temperature range.

In some embodiments of the present invention, an optical axis of the at least one RCPD coincides with an optical axis of the at least one RCLED. This has the advantage that in a homogeneous medium light emitted by the RCLED is well coupled into the RCPD.

In some embodiments of the present invention, the light emitted by the at least one optical emitter is guided to the at least one optical receiver via components that redirect light through refraction and/or reflection. This has the advantage that light emitted by the RCLED is well coupled into the RCPD in a large variety of geometries.

In some embodiments of the invention, the emission spectrum of the RCLED and the absorption spectrum of the RCPD each have a maximum between 940 nm and 980 nm. This has the advantage that the emitter-receiver system operates with infrared light which is not visible and thus does not perturb potential optical applications in the visible domain.

The optical emitter-receiver according to the present invention may for instance be used as part of a light barrier. With a spectrally matched RCLED/RCPD system, the light barrier has a high signal-to-noise ratio. In particular, the present invention relates to a light barrier comprising an optical emitter-receiver system like the one described above, wherein the light barrier is configured to generate a warning signal when an object breaks a light beam between at least one optical emitter and at least one optical receiver of the optical emitter-receiver system.

Furthermore, LED/photodiode systems are often employed in devices for the optical detection of moisture on a pane. Using a spectrally matched emitter-receiver system leads to a high signal-to-noise ratio of the optical moisture sensor. Therefore, the invention also relates to a rain sensor mounted on a first surface of a pane in order to detect an amount of moisture on an opposing second surface of the pane, the rain sensor comprising an optical emitter-receiver system as described above, wherein the at least one emitter is configured to emit light directed from the first surface to the second surface to form at least one rain-sensitive area on the second surface, and wherein the at least one receiver is operable to detect light emitted by the emitter and that has been internally reflected at the at least one rain-sensitive area, and to generate an output signal indicative of the amount of moisture on the rain-sensitive area.

Advantageously, the rain sensor is formed as a compact integrated system which comprises its own evaluation and control unit for driving said at least one emitter and for evaluating output signals generated by said receiver. This allows for a fast and flexible installation in various application environments.

The accompanying drawings are incorporated into and form a part of the specification to illustrate several embodiments of the present invention. These drawings together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention.

Further features and advantages will become apparent from the following more particular description of the various embodiments of the invention, as illustrated in the accompanying drawings, in which like references refer to like elements, and wherein:
- **Fig. 1**: shows a comparison of the spectrum of an incandescent light source (noise generator) with LED, RCLED (signal generators) emission, and PD absorption spectra;
- **Fig. 2**: shows a comparison of the signal-to-noise ratio of RCLED/PD, LED/PD, and RCLED/RCPD optical transmission,
- **Fig. 3A**: shows a schematic structure of a conventional LED or PD;
- **Fig. 3B**: shows the absorption spectrum of a conventional PD;
- **Fig. 3C**: shows a schematic structure of an RCLED;
- **Fig. 3D**: shows the absorption spectrum of an RCPD detecting radiation by an RCLED which is the same optoelectronic element;
- **Fig. 4**: shows an optical moisture sensor using a RCLED/RCPD emitter/receiver pair.

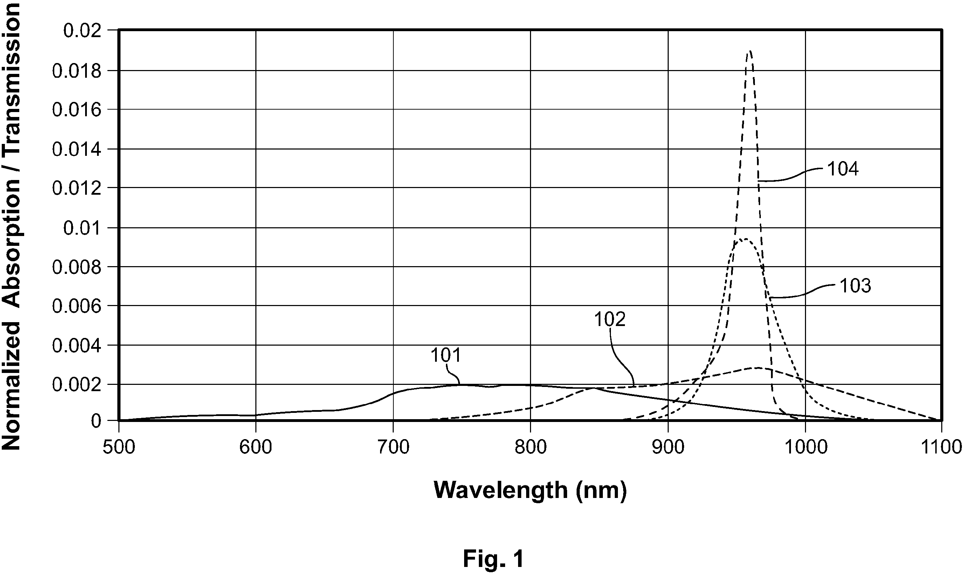

The present invention will now be explained in more detail with reference to the Figures, and first referring to Fig. 1.

The signal-to-noise ratio of an emitter-receiver sensor system depends on the emission spectrum of the emitter, the absorption spectrum of the receiver, and the spectrum of the ambient light. Figure 1 shows a comparison between the normalized absorption and transmission spectra of various components. In particular, curve 101 shows the emission spectrum of an incandescent lamp. Curve 102 illustrates the normalized absorption spectrum of a photodiode (PD). Curve 103 shows the emission spectrum of a conventional light emitting diode (LED), while curve 104 illustrates the emission spectrum of a resonant cavity light emitting diode (RCLED).

As can be seen, in the given example the emission spectrum 104 of the RCLED exhibits a peak between 930 nm and 975 nm, while the absorption spectrum 102 of the PD exhibits a broader maximum in the range 820 nm and 1050 nm. The spectrum 101 of the incandescent light exhibits a very broad maximum between 680 nm and 920 nm. Consequently, if the total power of the light emitted by the RCLED and entering the active region of the PD and the total power of the incandescent light entering the active region of the PD are the same, the PD will absorb more radiation from the RCLED than from the incandescent light.

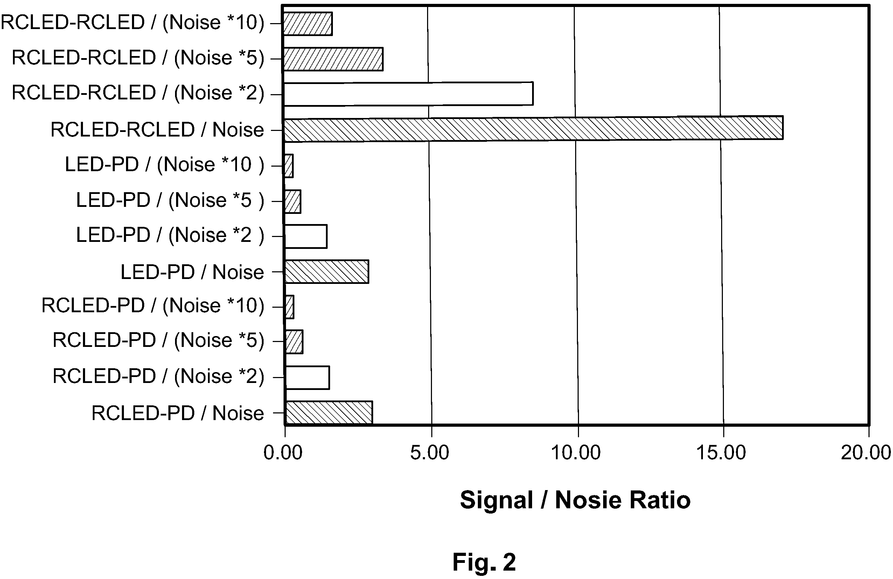

Figure 2 shows the noise levels associated with a system comprising an LED as an emitter and a PD as receiver, also referred to as LED-PD system. If normalized to the same overall intensities and multiplying the noise by two yields a signal-to-noise ratio of 2.

The signal-to-noise ratio can be improved if the emission spectrum is narrowed by using a resonant cavity LED (RCLED).

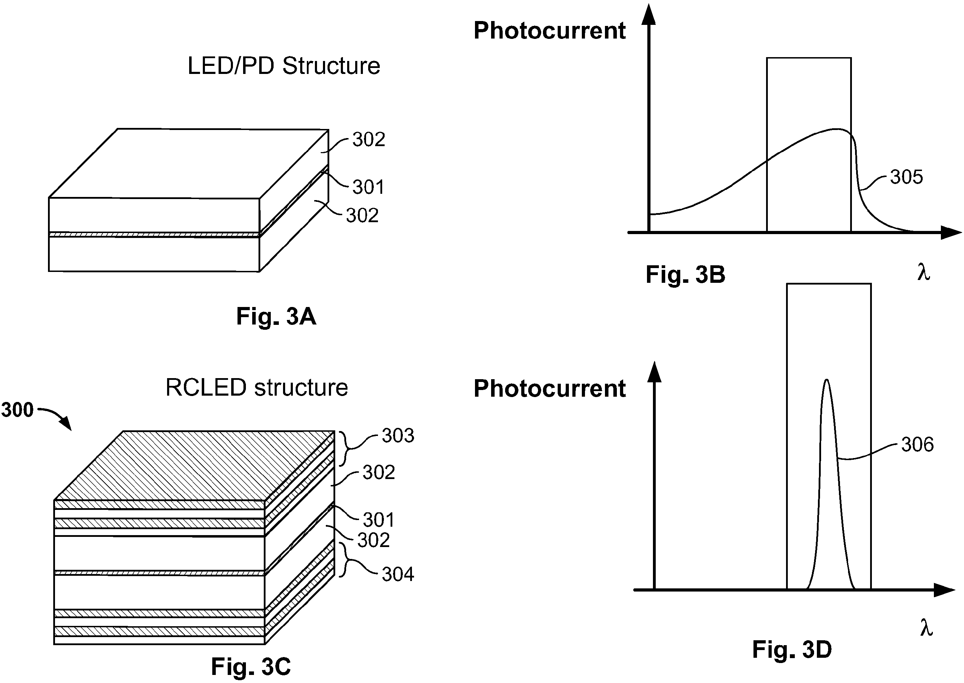

Figures 3A and 3C compare the schematic structure of a conventional LED or a conventional PD and an RCLED or an RCPD system. Figure 3A displays the structure of a conventional LED or a conventional PD. The device comprises the active region 301 where light is generated in the case of the LED and where light is detected in the case of the PD, and a spacer region 302 at each side of the active region 301. Light is emitted normal to the active layer. Fig. 3C displays the schematic structure of an RCLED or a RCPD, comprising the active region 301, a spacer 302 at each side of the active region 301, as well as a distributed Bragg reflector (DBR) at the top 303 and the bottom 304.

Referring back to Figure 1, this Figure shows that the emission spectrum 104 of an RCLED is significantly narrowed compared to the emission spectrum 103 of a conventional LED. Though an increase in the signal-to-noise ratio may be expected, it should be considered that the absorption spectrum of a PD is much broader than the emission spectrum of an LED, such that the signal-to-noise ratio may be limited by the width of the absorption spectrum. Indeed, replacing the LED by and RCLED, each using in conjunction with a conventional PD, has no significant effect on the signal-to-noise ratio of the emitter-receiver system.

This changes if also the photodiode is put into a resonant cavity.

A high signal-to-noise ratio is achieved if the emission spectrum of the RCLED and the absorption spectrum of the RCPD match or are at least very similar. In order to achieve close similarity between the corresponding spectra, the same materials and doping characteristics may be chosen for the p-n junction of the RCLED and the p-n junction of the RCPD. However, this might not be sufficient to achieve a good matching of the corresponding absorption and emission spectra. This is because the emission spectrum of a p-n junction may differ from the absorption spectrum of the same p-n junction, due to non-radiative transitions occurring upon emission but not upon absorption. The presence of a Fabry-Perot cavity in an emitter and a receiver, though, may have the effect that parts of the emission spectrum of the emitter and the absorption spectrum of the receiver are selected in such a way that the emission spectrum of the corresponding RCLED matches the absorption spectrum of the corresponding RCPD. A good match for these spectra may be achieved when the same geometry (in particular, length) may be chosen for the Fabry-Perot cavity.

Figure 3B and 3D compares the PD absorption spectra of an LED/PD system and an RCLED/RCPD system. Fig. 3B shows the absorption spectrum of a conventional PD detecting radiation from a conventional LED. Fig. 3D shows the absorption spectrum of an RCPD detecting the radiation of a spectrally matched RCLED. Comparison to Figure 3B shows that the presence of the DBR in both the emitter and the detector narrows the spectrum significantly.

Figure 2 shows that the signal-to-noise levels associated with a spectrally matched RCLED/RCPD system is increased by an order of magnitude compared to a RCLED/PD or an LED/PD system. In addition, using the same materials for the p-n junction and the same geometry of the Fabry-Perot cavity ensures a perfect spectral matching between the emitter and the filter over a large temperature range (-40° to 85°C for automotive applications).

As indicated for an RCLED in Figure 1, in some embodiments the RCLED/RCPD systems each have peaks between 940 and 980 nm. The advantage is that this is not in the visible range such that radiation from the RCLED penetrating to the outside of housing of the RCLED/RCPD system would not disturb a user of this system.

The optical emitter-receiver described here may be used as part of a light barrier. With a spectrally matched RCLED/RCPD system, the light barrier has a high signal-to-noise ratio and is therefore more sensitive and accurate.

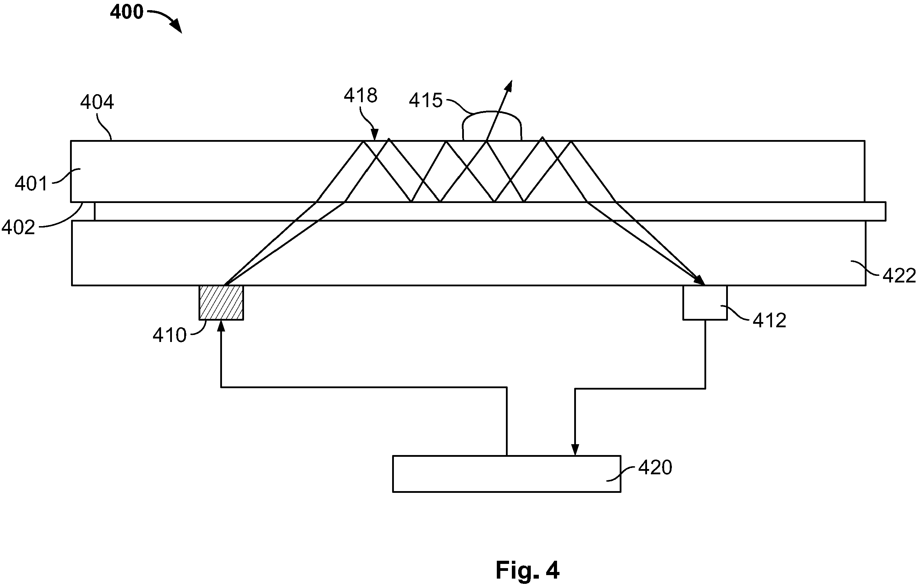

Figure 4 shows a further embodiment of the present invention. LED/photodiode systems are often employed in devices for the optical detection of moisture on a pane. Using a spectrally matched emitter-receiver system would lead to a high signal-to-noise ratio of the optical moisture sensor.

Therefore, as indicated in Figure 4, the invention also relates to an optical RCLED/RCPD system, wherein the emitter-receiver pair is part of an optical rain sensor 400. The rain sensor 400 can be mounted on a first surface 402 of a transparent pane 401, for instance the windshield of a vehicle, in order to detect an amount of moisture 415 on an opposing second surface 404 of the pane. The rain sensor 400 comprises at least one emitter 410 for emitting electromagnetic radiation, directed from the first surface 402 to the second surface 404 to form at least two rain-sensitive areas 418 on the second surface 404, at least one receiver 412 for sensing radiation emitted by the emitter and that has been internally reflected at the rain-sensitive areas 418, and for generating an output signal indicative of the amount of moisture on the rain-sensitive area 418.

Furthermore, the rain sensor 400 is advantageously formed as a compact integrated system which comprises its own evaluation and control unit 420 for driving said at least one emitter 410 and for evaluating output signals generated by said receiver 412. This allows for a fast and flexible installation in various application environments. Moreover, a light guiding element 422 is provided that redirects the radiation light through refraction and/or reflection, for instance by means of lenses and/or mirrors.

Many other applications, in particular, communication applications, also can benefit from the usage of spectrally matched RCLED/RCPD pairs with improved signal-to-noise ratio. In general, improved signal to noise ratios would imply that the currents needed to operate the devices can be reduced which would lead to reduced energy costs.

An exemplary embodiment is described herein. Variations of this embodiment may become apparent to those of ordinary skill in the art upon reading the foregoing description. The inventor(s) expect skilled artisans to employ such variations as appropriate, and the inventor(s) intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

**Reference Numerals:**

| **Reference Numeral** | **Description** |
|---|---|
| 101 | Emission spectrum of incandescent lamp |
| 102 | Normalized absorption spectrum of a photodiode |
| 103 | Emission spectrum of conventional LED |
| 104 | Emission spectrum of RCLED |
| 301 | Active region |
| 302 | Spacer region |
| 303 | Top DBR |
| 304 | Bottom DBR |
| 305 | Absorption spectrum of conventional PD detecting radiation from conventional LED |
| 306 | Absorption spectrum of RCPD detecting radiation from RCLED |
| 400 | Rain sensor |
| 401 | Pane |
| 402 | First surface of a pane |
| 404 | Second surface of a pane |
| 410 | Emitter |
| 412 | Receiver |
| 415 | Moisture |
| 418 | Rain-sensitive area |
| 420 | Evaluation and control unit |
| 422 | Light guiding element |

## Claims

1. Optical emitter-receiver system comprising:
at least one optical emitter (300, 410) comprising at least one first resonant cavity light emitting diode (RCLED) with first active region (301) comprising a p-n junction diode configured to emit light when activated, two first spacer regions (302) on each side of the first active region (301), and a first Fabry-Perot cavity (303, 304),
and at least one optical receiver (300, 412) comprising at least one second resonant cavity photodiode (RCPD) with a second active region (301) comprising a p-n junction diode configured to convert light into an electrical current, two second spacer regions (302) on each side of the second active region (301), and a second Fabry-Perot cavity (303, 304),
wherein the RCPD is arranged such as to detect light emitted by the RCLED, and wherein the emission spectrum of the optical emitter matches the absorption spectrum of the optical receiver.

2. Optical emitter-receiver system according to claim 1, wherein the emitter (300, 410) and the receiver (300, 412) comprise identical active regions (301).

3. Optical emitter-receiver system according to claim 1 or 2, wherein the first Fabry-Perot cavity comprises a multilayer distributed Bragg reflector (DBR, 303) with a reflectivity greater than 0.99.

4. Optical emitter-receiver system according to one of the preceding claims, wherein the first Fabry-Perot cavity (303, 304) comprises a first mirror with a low to moderate reflectivity between 0.25 and 0.99.

5. Optical emitter-receiver system according to one of the preceding claims, wherein the second Fabry-Perot cavity (303, 304) comprises a multilayer distributed Bragg reflector DBR with a reflectivity greater than 0.99.

6. Optical emitter-receiver system according to one of the preceding claims, wherein the second Fabry-Perot cavity (303, 304) comprises a second mirror with a low to moderate reflectivity between 0.25 and 0.99.

7. Optical emitter-receiver system according to one of the preceding claims, wherein the spacer regions (302) of the emitter (300, 410) and the receiver (300, 412) have an identical thickness.

8. Optical emitter-receiver system according to claims 4 and 6, wherein the first mirror and the second mirror have the same reflectivity.

9. Optical emitter-receiver system according to one of the preceding claims, wherein the at least one optical emitter (300, 410) and the at least one optical receiver (300, 410) are formed by identical optoelectronic components.

10. Optical emitter-receiver system according to one of the preceding claims, wherein an optical axis of the RCPD (300, 412) coincides with the optical axis of the RCLED (300, 410).

11. Optical emitter-receiver system according to one of the claims 1 to 9, wherein the light emitted by the RCLED (300, 410) is guided to the RCPD (300, 412) via at least one light guiding element (422) for redirecting light through refraction and/or reflection.

12. Optical emitter-receiver system according to one of the pending claims, wherein the emission spectrum of the RCLED (300, 410) and the absorption spectrum of the RCPD (300, 412) each have a maximum between 940 nm and 980 nm.

13. Light barrier comprising an optical emitter-receiver system according to one of the claims 1 to 12, wherein the light barrier is configured to generate a warning signal when an object breaks a light beam between at least one optical emitter (300, 410) and at least one optical receiver (300, 412) of the optical emitter-receiver system.

14. Rain sensor mounted on a first surface of a pane (400) in order to detect an amount of moisture (415) on an opposing second surface (404) of the pane, the rain sensor comprising:
an optical emitter-receiver system according to one of the claims 1 to 12, wherein the at least one emitter (410) is configured to emit light directed from the first surface (102) to the second surface (404) to form at least one rain-sensitive area (418) on the second surface,
and wherein the at least one receiver (412) is operable to detect light emitted by the emitter and that has been internally reflected at the at least one rain-sensitive area, and to generate an output signal indicative of the amount of moisture on the rain-sensitive area.

15. Rain sensor according to claim 14, further comprising an evaluation and control unit (420) for driving said at least one emitter (300, 410) and for evaluating output signals generated by said receiver (300, 412).
